# EUROPEAN PATENT SPECIFICATION

(11) **EP 3 736 051 B1**
(45) Date of publication and mention of the grant of the patent: **28.09.2022**
(21) Application number: 20167543.6
(22) Date of filing: 01.04.2020
(51) Int. Cl.: B06B 1/06, H01L 41/187

(54) **ULTRASONIC SENSOR**
ULTRASCHALLSENSOR
CAPTEUR ULTRASONORE

(30) Priority: 09.05.2019 JP 2019088954
(43) Date of publication of application: 11.11.2020
(73) Proprietor: Honda Electronics Co., Ltd., Toyohashi-shi, Aichi 441-3193 (JP)
(72) Inventor: NAGAREDA, Kenji, Toyohashi-shi, Aichi 4413193 (JP)
(74) Representative: Dennemeyer & Associates S.A.

(56) References cited:
- JP-A- 2004 072 461
- US-A1- 2017 059 378
- FU J ET AL: "Phase transition characteristics and piezoelectric properties of compositionally optimized alkaline niobate based ceramics", JOURNAL OF ALLOYS AND COMPOUNDS, ELSEVIER SEQUOIA, LAUSANNE, CH, vol. 486, no. 1-2, 3 November 2009 (2009-11-03), pages 790-794, XP026705334, ISSN: 0925-8388, DOI: 10.1016/J.JALLCOM.2009.07.065 [retrieved on 2009-07-18]
- CHEN QIANG ET AL: "Piezoelectric properties of K4CuNb8O23 modified (Na0.5K0.5)NbO3 lead-free piezoceramics", JOURNAL OF APPLIED PHYSICS, AMERICAN INSTITUTE OF PHYSICS, US, vol. 102, no. 10, 21 November 2007 (2007-11-21), pages 104109-104109, XP012101167, ISSN: 0021-8979, DOI: 10.1063/1.2815498
- TOSHIO OGAWA ET AL: "Poling Field Dependence of Piezoelectric Properties and Hysteresis Loops of Polarization versus Electric Field in Alkali Niobate Ceramics", JAPANESE JOURNAL OF APPLIED PHYSICS, vol. 48, no. 9, 24 September 2009 (2009-09-24), page 09KD07, XP055728230, JP ISSN: 0021-4922, DOI: 10.1143/JJAP.48.09KD07

## Description

### Technical Field

This invention relates to an ultrasonic sensor, including a piezoelectric element that transmits and receives ultrasonic waves, and an acoustic-matching layer that is joined to the piezoelectric element.

### Technical Background

Conventionally, an ultrasonic sensor, using ultrasonic waves for measuring distance and for detecting an obstacle or the like, is known. An ultrasonic sensor generally includes a disk-shaped piezoelectric element and an acoustic-matching layer joined to the piezoelectric element. Currently, a piezoelectric element having excellent piezoelectric characteristics, one containing a lead compound such as lead-zirconate titanate (PZT), has been put into practical use. There is concern however that a piezoelectric element containing a lead compound has a bad influence on the environment. Therefore, a piezoelectric element containing no lead compound has recently attracted the public attention while promoting research and development. As a piezoelectric element containing no lead compound, piezoelectric elements, for example made of alkali-niobate ceramics, have been proposed (see e.g. Patent Documents 1 to 6). US 2017/059378 A1 (Patent Document 7) discloses an electromechanical transformation device for an ultrasonic flow meter comprising an alkaline niobate piezoelectric ceramic composition, etc. Fu J et. al., Journal of Alloys and compounds, Elsevier Sequoia, Lausanne, CH vol. 486, no. 1-2, 3 November 2009 (2009-11-03), pages 790-794 (Non-Patent Document 1) studies phase transition characteristics and piezoelectric properties of compositionally optimized alkaline niobate based ceramics.

### Prior Arts

### Patent Documents

Patent Document 1: Japanese published unexamined patent application No. 2015-19317 (paragraph [0031], FIG. 5, etc.)
Patent Document 2: Japanese published unexamined patent application No. H9-100156 (paragraph [0002], Table 4, 5, etc.)
Patent Document 3: Japanese published unexamined patent application No. 2016-139643 (paragraphs [0020], [0030], FIG. 1, etc.)
Patent Document 4: Japanese Patent No. 5715309 (Claim 16, paragraphs [0060] to [0064], FIG. 6, etc.)
Patent Document 5: Japanese Patent No. 6072025 (Claim 5, etc.)
Patent Document 6: Japanese Patent No. 4857464 (FIG. 1, etc.)
Patent Document 7: US 2017/059378 A1
Non-Patent Document 1 : Fu J et. al., Journal of Alloys and compounds, Elsevier Sequoia, Lausanne, CH vol. 486, no. 1-2, 3 November 2009 (2009-11-03), pages 790-794

### Summary of the invention

### Problems to be resolved by the invention

However, a piezoelectric element made of alkali-niobate-based ceramics is currently still inferior in piezoelectric properties, such as a piezoelectric-distortion constant and an electromechanical-coupling coefficient, as compared with a piezoelectric element made of lead-zirconate titanate (PZT). For this reason, the market recognizes that an ultrasonic sensor comprising a piezoelectric element made of alkali-niobate ceramics has poor transmission/reception sensitivity, so that it is still not alternatively replaced. Also, lead in piezoelectric ceramics is excluded in the RoHS (Restriction of Hazardous Substances) Directive that regulates environmentally unfriendly lead, because the performance of a piezoelectric element not containing a lead compound is inferior to that of PZT.

In addition, the recent development of digital-signal-processing technology is expected to bring about a change in the needs of ultrasonic sensors. For example, it is known that conducting frequency analysis by performing CHIRP transmission improves the S/N ratio and resolution ability, but this requires a wideband ultrasonic sensor. The broadband ultrasonic sensor has the feature that reverberation during transmission is shortened. Further, when transmission and reception are performed by a single ultrasonic sensor, the dead zone is shortened, and detection at a shorter distance becomes possible. Therefore, in the future, it is expected that the demand for an ultrasonic sensor, emphasizing more broadband characteristics than transmission /reception sensitivity, will increase.

This invention has been made in light of the above problems, and its aim is to provide an ultrasonic sensor that can make the ultrasonic transmission/reception sensitivity the same or higher than in the case where PZT is used and which can expand a frequency band as compared to the case where PZT is used, even when a piezoelectric element made of lead-free alkali-niobate ceramics is used.

### Means for solving the problems

To solve the above-mentioned problem, the first aspect of this invention refers to an ultrasonic sensor according to claim 1 or claim 2.

According to the first aspect of the invention, since the mechanical-quality factor Qm of the piezoelectric element made of the alkali-niobate-based ceramic is as low as 50 or less, the oscillation of the piezoelectric element quickly subsides after transmitting the ultrasonic waves. The piezoelectric element has a radial-frequency constant Np of 2800 Hz · m or more, which is greater than the frequency-constant Np in the case where the piezoelectric element is made of lead-zirconate titanate (PZT). In this case, to output ultrasonic waves of a desired frequency, it is necessary to make the outer diameter of the piezoelectric element larger than that of the piezoelectric element that is made of lead-zirconate titanate. As a result, however, the area of the acoustic-emitting surface of the piezoelectric element is increased, so that the transmission/reception sensitivity of the ultrasonic sensor can be improved. In addition, as the area of the acoustic-emitting surface increases, the directivity of the ultrasonic wave that is output from the piezoelectric element also increases. Further, since the piezoelectric element has a piezoelectric constant d33 of 250pC/N or more, and although it is inferior to the piezoelectric-constant d33 (about 380pC/N) in the case that the piezoelectric element is made of lead-zirconate titanate, an effect is obtained by defining the frequency-constant Np as described above as radial oscillation is used and as the transmission/reception sensitivity of the ultrasonic sensor can be made equal to or higher than that of the ultrasonic sensor in the case that lead-zirconate titanate is used.

By the way, when the thickness t of the acoustic-matching layer that is joined to the piezoelectric element is set to one fourth of the wavelength λ of the ultrasonic-wave propagating within the acoustic-matching layer, the phase of the transparent wave corresponds to that of the reflection wave, while the ultrasonic wave of the resonance frequency f is propagating within the acoustic-matching layer, thus making it possible to optimize (maximize) the transmission/reception sensitivity. However, the thickness of the acoustic-matching layer is preferably in the range of λ/4±20% (the first aspect of this invention), particularly preferable that it is in the range of λ/4±20% and out of the range of λ/4±1% (the second aspect of this invention). As such, the frequency band of the ultrasonic sensor can be broadened, compared with the case where the piezoelectric element is made of lead-zirconate titanate, thus making it also possible to improve the temperature characteristics of the ultrasonic sensor.

The third aspect of this invention refers to an ultrasonic sensor, according to the first or second aspect of this invention, characterized in that the piezoelectric element has a density of 4.4 g/cm³±10%.

According to the third aspect of the present invention, the density of the piezoelectric element is lower than that in the case where the piezoelectric element is made of lead-zirconate titanate, and that it is possible to make the characteristic-acoustic impedance of the piezoelectric element closer to the characteristic-acoustic impedance of the acoustic-matching layer. As a result, the characteristic-acoustic impedance of the piezoelectric element is reduced, so that ultrasonic waves emitted from the piezoelectric element are easily transmitted to the acoustic-matching layer. In fact, the ultrasonic waves can easily be propagated within the piezoelectric element, thus further improving the transmission/reception sensitivity of the ultrasonic sensor.

The invention refers to an ultrasonic sensor characterized in that when a frequency range at the transmission/reception sensitivity that is reduced by 6dB from the maximum transmission/reception sensitivity is the frequency band, when a lower-limit frequency in the frequency band is the lower-limit frequency, when an upper-limit frequency in the frequency band is the upper-limit frequency, when an intermediate value between the lower-limit frequency and the upper-limit frequency is the center frequency fm, when the difference between the lower-limit frequency and the upper-limit frequency is the frequency bandwidth Δf, and when the ratio between the bandwidth Δf and the center-frequency fm is the fractional bandwidth Δf/fm, then the fractional bandwidth Δf/fm is 15% or more.

According to the invention, the fractional bandwidth Δf/fm of the piezoelectric element is 15% or more, that is, it is much greater than the fractional bandwidth Δf/fm (6%) in the case where the piezoelectric element is made of lead-zirconate titanate. In this case, it is possible to contribute to an improvement of the temperature characteristics of the ultrasonic sensor.

### Effects of the invention

As described in detail, above, according to the first to third aspects of this invention, even when a piezoelectric element made of an alkali-niobate ceramic containing no lead is used, it is possible to provide an ultrasonic sensor of which the transmission/reception sensitivity can be set equivalent to or even higher than in the case where PZT is used as well as in which the frequency band can also be expanded as compared to the case where PZT is used.

### Brief description of the drawings

FIG. 1 is a schematic-configuration diagram showing the ultrasonic-sensor system according to an embodiment of this invention.
FIG. 2 is a cross-sectional view showing the ultrasonic sensor.
FIG. 3 is a block diagram showing the electrical configuration of the ultrasonic-sensor system.
FIG. 4 is a schematic-configuration diagram showing the ultrasonic-sensor system when an obstacle is detected.
FIG. 5 is a graph showing the relationship between the frequency and transmission/reception sensitivity in Working Example A and Comparative Example A.
FIG. 6 is a graph showing the relationship between the frequency and transmission/reception sensitivity at 0°C, 20°C, 40°C and 60°C in Working Example A.
FIG. 7 is a graph showing the relationship between the frequency and transmission/reception sensitivity at 0°C, 20°C, 40°C and 60°C in Comparative Example A.
FIG. 8 is a graph showing the relationship between the temperature and transmission/reception sensitivity in Working Example A and Comparative Example A.
FIG. 9 is a graph showing the relationship between the frequency and transmission/reception sensitivity in Working Examples B10, B20 and B26.
FIG. 10 is a graph showing the relationship between Δf/fm and t/λ in Working Examples B1 to B37.
FIG. 11 is a graph showing the relationship between the maximum transmission/reception sensitivity and t/λ in Working Examples B1 to B37.

### Modes for carrying out the invention

Hereinafter, an ultrasonic-sensor system, an embodiment of which this invention is embodied, is described in detail with reference to the drawings.

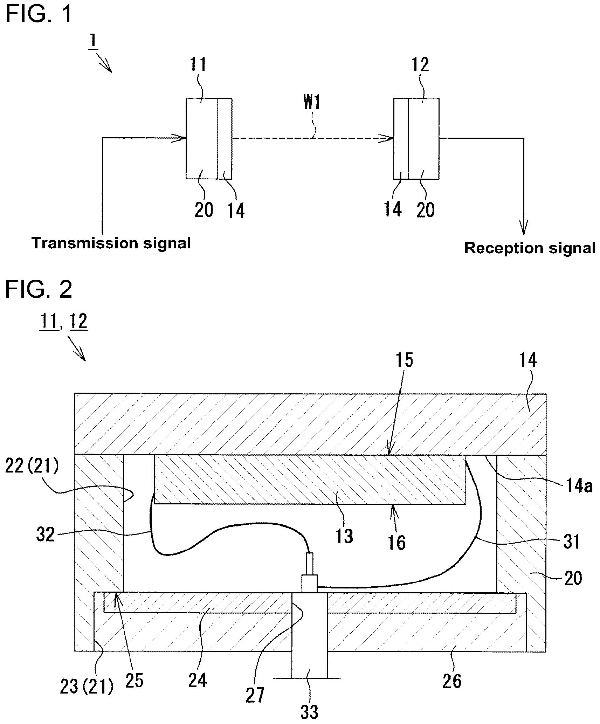

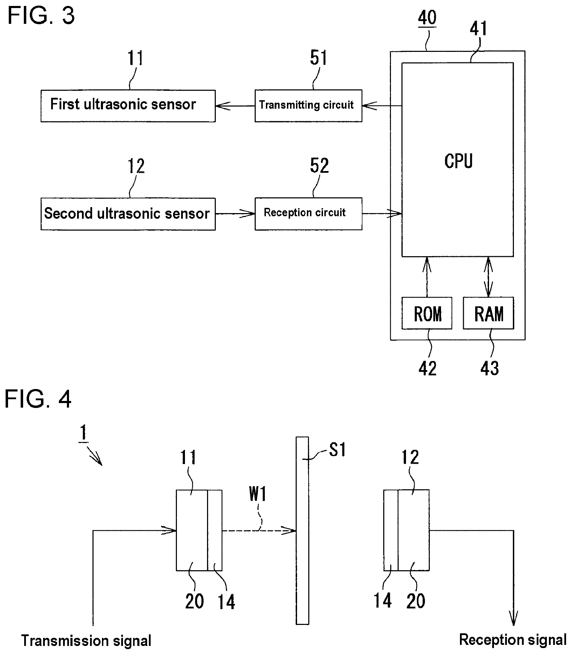

As shown in FIG. 1, the ultrasonic-sensor system 1, as an embodiment of this invention, is a device that detects the presence or absence of an obstacle S1 (see FIG. 4) by irradiating an ultrasonic wave W1 into the air. The ultrasonic-sensor system 1 includes a pair of ultrasonic sensors 11 and 12 that are arranged facing each other. Specifically, the first ultrasonic sensor 11 is provided at an upstream position of the ultrasonic-sensor system 1, and the second ultrasonic sensor 12 is provided at a downstream position of the ultrasonic-sensor system 1. The two ultrasonic sensors 11 and 12 have the same structure.

As shown in FIG. 2, the ultrasonic sensors 11 and 12 include a piezoelectric element 13, for transmitting and receiving the ultrasonic wave W1, and an acoustic-matching layer 14 that is joined to the piezoelectric element 13. The piezoelectric element 13, as the embodiment of this invention, is of a disk shape with an outer diameter of 16 mm and a thickness of 2.5mm. The acoustic-matching layer 14 is made of a mixed material of a glass balloon and an epoxy resin and has a specific gravity of 0.5 or less. The acoustic-matching layer 14 is of a disk shape with an outer diameter of 24mm and a thickness of 3.0mm. That is, the acoustic-matching layer 14, as the embodiment of this invention, is a plate-like object having an outer diameter greater than the outer diameter of the piezoelectric element 13 and having a thickness greater than that of the piezoelectric element 13.

Also, the piezoelectric element 13 has a front surface 15 that is joined to the acoustic-matching layer 14, and a rear surface 16 that is located on the opposite side of the front surface 15. A front-side electrode layer (not shown in the drawings) is formed on the front surface 15 of the piezoelectric element 13, and a rear-side electrode layer (not shown in the drawings) is formed on the rear surface 16 of the piezoelectric element 13. In the embodiment of this invention, the whole front surface 15 of the piezoelectric element 13 is joined to the acoustic-matching layer 14 through a front-electrode layer and an adhesive layer (not shown in the drawings). The front surface 15 that is joined to the acoustic-matching layer 14 functions as an acoustic-emitting surface for irradiating (transmitting) the ultrasonic wave W1 when the piezoelectric element 13 oscillates in the radial direction. Also, the embodiment of this invention, which has the resonance frequency f on the radial direction of the piezoelectric element 13, has the acoustic velocity c of the longitudinal wave (ultrasonic wave W1) propagating within the acoustic matching layer 14, has the wavelength λ of the ultrasonic wave W1 propagating within the acoustic-matching layer 14, and has the thickness t of the acoustic-matching layer 14, which satisfies the relationship of λ=c/f as well as another relationship of t=λ/4±20%. That is, the thickness t of the acoustic-matching layer 14 is ±20%, which is one-fourth as much as the wavelength λ of the ultrasonic wave W1.

The piezoelectric element 13, as the embodiment of this invention, is formed using a lead-free ceramic-piezoelectric material, specifically, an alkali-niobate-based ceramic-piezoelectric material. Preferable examples of the alkali-niobate-based ceramic-piezoelectric material include a potassium-sodium niobate-based (KNN-based) ceramic-piezoelectric material having a perovskite structure, which is a solid solution of potassium niobate and sodium niobate. The KNN-based ceramic-piezoelectric material refers to a material containing at least K (potassium), Na (sodium) and Nb (niobium) as the major metal components, and such components contains little or no toxic and harmful elements including Pb (lead). Such a KNN-based ceramic-piezoelectric material may contain an alkali metal such as Li (lithium), as well as K (potassium) and Na (sodium). In addition to Nb (niobium), the KNN-based ceramic-piezoelectric material may also contain an alkaline-earth metal such as Ca (calcium), Sr (strontium), Ba (barium), Ta (tantalum), Sb (antimony) or the like. The KNN-based ceramic-piezoelectric material may also include a small amount of Bi (bismuth), Fe (iron), Al (aluminum), Mn (manganese), Co (cobalt), Ni (nickel) or the like.

In particular, in the embodiment of this invention, the piezoelectric element 13 is a KNN-based ceramic-piezoelectric material, represented by the following composition formula (1), using a small amount of Bi (bismuth) and Fe (iron) of a metallic element as additives.

{Liₓ (K_{1-y}Na_{y}) ₁₋ₓ} (Nb_{1-z}Sb_{z}) O₃ .......... (1)

Here, assuming that the additive amount (mol ratio) of Bi is v and the additive amount (mol ratio) of Fe is w, the composition of the piezoelectric element satisfies the range of 0.03≦x≦0.045, 0.5≦y≦0.58, 0.03≦z≦0.045 and 0.006≦v<w≦0.010. In the case that a KNN-based ceramic-piezoelectric material that satisfies such a composition range is used, it is easier to obtain good piezoelectric characteristics (e.g., a piezoelectric constant d33 being 250pC/N or more and a Curie temperature Tc being 330°C or more), and good electrical characteristics (e.g., the radial electromechanical- coupling coefficient Kp being 0.44 or more, the relative-dielectric constant _{ε33}^{T}/_{ε0} being 1,390 or more and the dielectric-loss tan δ being 0.03 or less).

Furthermore, the piezoelectric element 13 of the embodiment of this invention has a mechanical-quality factor Qm of 50 or less, which is less than the mechanical-quality factor Qm (=75) in the case that the piezoelectric element 13 is made of lead-zirconate titanate (PZT). Also, the piezoelectric element 13 has a frequency constant Np in the radial direction, which is 2800Hz · m or more. On the other hand, in the conventional art in which the piezoelectric element 13 is made of lead-zirconate titanate, the frequency constant Np in the radial direction is 2095 Hz · m. Therefore, the frequency constant Np of the piezoelectric element 13 is 1.3 times (130%) or more as much as the frequency constant Np in the case where the piezoelectric element 13 is made of lead-zirconate titanate.

The "radial-frequency constant Np" refers to the size of the outer diameter of the piezoelectric element 13 that is required when outputting the ultrasonic wave W1 of a specific frequency. For example, when the ultrasonic wave W1 of 100 kHz is output from the piezoelectric element 13 of the embodiment of this invention, an outer diameter of 28.00mm (=2800/100) or more is required. On the other hand, when outputting the ultrasonic wave W1 of 100kHz in the conventional art, in which the piezoelectric element 13 is made of lead-zirconate titanate (PZT), an outer diameter of 20.95 mm (= 2095/100) is required. Therefore, the outer diameter of the piezoelectric element 13 is, e.g., 30% or more greater than the outer diameter, as compared with that of the piezoelectric element 13 made of lead-zirconate titanate.

Furthermore, the density of the piezoelectric element 13 of the embodiment of this invention is 4.4g/cm³±10%, that is, 3.96g/cm³ or more and 4.84g/cm³ or less. On the other hand, in the conventional art of which the piezoelectric element 13 is made of lead-zirconate titanate (PZT), the density of the piezoelectric element is 7.5g/cm³. Therefore, the density of the piezoelectric element 13 is lower than the density in the case where the piezoelectric element 13 is made of lead-zirconate titanate.

Then, as shown in FIG. 2, the ultrasonic sensors 11 and 12 are fixed to the case 20, with the piezoelectric element 13 being accommodated therein. Specifically, the case 20 is formed in a substantially cylindrical shape using aluminum and has a housing hole 21 opening into the upper end and the lower end. The housing hole 21 includes a small-diameter portion 22 and a large-diameter portion 23 located at the lower-end side of the small-diameter portion 22. A step surface 25 for locking the divider 24 is formed at the connection between the small-diameter portion 22 and the large-diameter portion 23. The divider 24 is formed in a disk shape using a resin material such as an epoxy resin or the like, and when the divider 24 is housed in the large-diameter portion 23 and abuts on the step surface 25, the lower-end-side opening of the housing hole 21 is closed. The divider 24 is formed of an epoxy resin but may possibly be formed of other materials as long as they have sufficient strength that does not cause deformation. A space (recess) formed by the divider 24 and the case 20 is filled with a sealing material 26 made of silicone resin. On the other hand, the piezoelectric element 13 of the ultrasonic sensors 11 and 12 is stored in the small-diameter portion 22 of the housing hole 21. The upper-end side opening of the housing hole 21 is closed by the acoustic-matching layer 14 of the ultrasonic sensors 11 and 12.

As shown in FIG. 2, the first end of the first-lead wire 31 is connected to the front-surface-electrode layer of the piezoelectric element 13, and the first end of the second-lead wire 32 is connected to the rear-surface-electrode layer of the piezoelectric element 13. The first end of the first-lead wire 31 is connected to a side terminal (not shown in the drawings) extending outward from the front-electrode layer by soldering. The first end of the second-lead wire 32 is connected to the rear-surface-electrode layer by soldering. Then, the second end of the first-lead wire 31 and the second end of the second-lead wire 32 are connected to a cable 33 made of a single-core-shielded wire by soldering. The cable 33 is pulled out of the case 20 through the through-hole 27 provided in the center of the divider 24. An acoustic-absorbing material (not shown in the drawings) is filled in a space that is formed by the case 20, by the acoustic-matching layer 14, and by the divider 24. The acoustic-absorbing material of the embodiment of this invention is a sponge in which holes are dispersedly arranged in a resin material and has the function of suppressing reverberation.

Next, the electrical configuration of the ultrasonic-sensor system 1 is described.

As shown in FIG. 3, the ultrasonic-sensor system 1 includes a control device 40 that comprehensively controls the whole system. The control device 40 is configured by a well-known computer made of a CPU 41, a ROM 42 and a RAM 43 or the like.

The CPU 41 is electrically connected to the first ultrasonic sensor 11 via the transmitting circuit 51 and is electrically connected to the second ultrasonic sensor 12 via the reception circuit 52. The transmitting circuit 51 outputs a transmission signal to the first ultrasonic sensor 11, so as to drive the first ultrasonic sensor 11. As a result, the first ultrasonic sensor 11 irradiates (transmits) the ultrasonic wave W1 toward the second ultrasonic sensor 12. In addition, a reception signal, generated when the second ultrasonic sensor 12 receives the ultrasonic wave W1, is input to the receiving circuit 52. The reception-signal input to the receiving circuit 52 is further input to the CPU 41.

Next, a method for detecting the obstacle S1 using the ultrasonic-sensor system 1 is described.

First, the power supply (not shown in the drawings) of the ultrasonic-sensor system 1 is turned on. Then, the CPU 41 of the control device 40 controls the transmitting circuit 51, so as to output a transmission signal to the first ultrasonic sensor 11, thus driving the first ultrasonic sensor 11. As a result, the piezoelectric element 13, constituting the first ultrasonic sensor 11, oscillates in the radial direction, and the ultrasonic wave W1 is irradiated (transmitted) to the second ultrasonic sensor 12 from the first ultrasonic sensor 11.

Then, the CPU 41 determines whether or not the obstacle S1 (see FIG. 4) exists between the first ultrasonic sensor 11 and the second ultrasonic sensor 12. Specifically, the CPU 41 determines whether or not the second ultrasonic sensor 12 has received the ultrasonic wave W1 within a predetermined time (for example, within the output time of the ultrasonic wave W1 from the first ultrasonic sensor 11). That is, the CPU 41 determines whether or not a received signal, generated upon reception of the ultrasonic wave W1, has been input within a predetermined time. If it is determined that the received signal has been input within the predetermined time, then the CPU 41 determines that the obstacle S1 does not exist between the first ultrasonic sensor 11 and the second ultrasonic sensor 12 (see FIG. 1). On the other hand, if it is determined that the received signal has not been input within the predetermined time, then the CPU 41 determines that the obstacle S1 exists between the first ultrasonic sensor 11 and the second ultrasonic sensor 12 (see FIG. 4).

After that, when the operator turns the power off, the control device 40 causes the transmitting circuit 51 and the reception circuit 52 to stop, and the irradiation of the ultrasonic wave W1 and the reception of the ultrasonic wave W1 are completed.

Hereinafter, the method for manufacturing the ultrasonic sensors 11 and 12 is described in detail.

Firstly, several different types of base-material powders (purity of 99% or more) to be the material (KNN-based ceramics) for forming the piezoelectric element 13 is prepared. Each base-material powder contains different metallic elements. Secondly, the base-material powders containing each different metal element are weighed and mixed in an alcohol for 24 hours by a ball mill, thus obtaining a mixed slurry. The type of base-material powder (compound) containing the metallic element is not particularly limited, but an oxide, a carbonate or the like of the metallic element can be preferably used.

Next, the obtained mixed slurry is dried, calcined at 900°C for three hours, and then pulverized by a ball mill for 24 hours. Further, polyvinyl alcohol is added as a binder and granulated. Then, the granulated powder is compressed at a pressure of 2 kN/cm² into a disk shape having an outer diameter of 18 mm and a thickness of 3mm, and such a compact is then fired at 1000 to 1200°C for 2.5 hours, thus obtaining a calcined body. The firing temperature at this time should be a temperature at which the calcined reaches maximum density between 1000 and 1200°C.

Next, both surfaces of the calcined body are polished in parallel. The outer-peripheral surface is further polished and processed into a disk having an outer diameter of 16mm and a thickness of 2.5mm, thus finally obtaining the piezoelectric element 13. Furthermore, a front-side-electrode layer is formed on the front surface 15 of the piezoelectric element 13, and a rear-side-electrode layer is formed on the rear surface 16 of the piezoelectric element 13. Specifically, a silver paste is applied to the front surface 15 and to the rear surface 16 of the piezoelectric element 13, respectively, and the applied silver paste is then fired at 700°C, thus forming a front-side-electrode layer and a rear-side-electrode layer. Subsequently, DC voltage of 3 kV/mm is applied between the front-side-electrode layer and the rear-side-electrode layer in silicone oil at 130°C for 20 minutes, thus polarizing the piezoelectric element 13 in the thickness direction.

Thereafter, the piezoelectric element 13 is joined to the acoustic-matching layer 14 via the front-side-electrode layer. Specifically, an adhesive (e.g. an epoxy-based adhesive or the like), to be an adhesive layer, is applied either to the surface of the front-side electrode layer or to the surface 14a of the acoustic-matching layer 14, thus bonding and fixing the piezoelectric element 13 onto the acoustic-matching layer 14. As a material for forming the acoustic-matching layer 14, a foam material (in this invention, a material obtained by mixing a glass balloon with an epoxy resin) is used. The density of the acoustic-matching layer 14 is 0.52g/cm³, and the acoustic-velocity c, calculated from the propagation time of the ultrasonic wave W1 propagating in the thickness direction within the acoustic-matching layer 14, is 2569 m/s. At this point, the ultrasonic sensors 11 and 12, as the embodiment of this invention, are complete.

After the ultrasonic sensors 11 and 12 are completed, soldering using lead-free solder is done, and the first end of the first-lead wire 31 is connected to the front-side-electrode layer via a side-face terminal (not shown in the drawings). At the same time, the first end of the second-lead wire 32 is connected to the rear-side-electrode layer. Also, soldering using lead-free solder is done, thus connecting both the second end of the first-lead wire 31 and the second end of the second-lead wire 32 to the cable 33. Next, the piezoelectric elements 13 of the ultrasonic sensors 11 and 12 are stored in the case 20. Then, an adhesive (an epoxy-based adhesive or the like) is applied either to the surface 14 of the acoustic-matching layer 14 or to the upper-end surface of the case 20, so that the acoustic-matching layer 14 is adhered to and fixed onto the upper-end surface of the case 20. As a result, the ultrasonic sensors 11 and 12 are secured to the case 20 (see FIG. 2). Also, the case 33 is inserted into the through-hole 27 of the divider 24, and a acoustic-absorbing material (not shown in the drawings) is filled in the space that is formed by the case 20 and the acoustic-matching layer 14. Thereafter, the divider 24 comes into contact with the step surface 25 of the case 20, so that the lower-end side opening of the housing hole 21 is closed. Furthermore, the space formed by the divider 24 and the case 20 is sealed with a sealing material 26 made of silicone resin.

Next, the method for evaluating the ultrasonic sensor and the results of such evaluation are herein described.

First, a measurement sample was prepared as follows. An ultrasonic sensor having a piezoelectric element made of KNN-based ceramics (HC-90KN manufactured by Honda Electronics Co., Ltd.) was prepared, that is, Working Example A. An ultrasonic sensor having a piezoelectric element made of lead-zirconate titanate-based ceramics (PZT-based ceramics) was then prepared, that is, Comparative Example A. Table 1 shows the dimensions of each part of Working Example A and of Comparative Example A. Table 2 shows the material characteristics of Working Example A and of Comparative Example A.

**Table 1**

| | Material of the piezoelectric element | Dimensions of the piezoelectric element | Dimensions of the matching layer | Dimensions of the case |
|---|---|---|---|---|
| Working Example A | KNN-based ceramics | Outer diameter: 16mm Thickness: 2.5mm | Outer diameter: 24mm Thickness: 3mm | Outer diameter: 24mm (inner diameter: 22mm) Thickness: 10mm |
| Comparative Example A | PZT-based ceramics | Outer diameter: 11mm Thickness: 2.5mm | Outer diameter: 19mm Thickness: 3mm | Outer diameter: 19mm (inner diameter: 14mm) Thickness: 10mm |

**Table 2**

| | Working Example A | Comparative Example A |
|---|---|---|
| Material of Piezoelectric element | KNN-based ceramics | PZT-based ceramics |
| Electromechanical coupling coefficient Kp | 0.48 | 0.58 |
| Relative dielectric constant _{ε33}^{T}/ε₀ | 1440 | 1900 |
| Frequency constant Np(m · Hz) | 3090 | 2095 |
| Piezoelectric constant d33 (pC/N) | 255 | 380 |
| Mechanical quality factor Qm | 40 | 75 |
| Density (g/cm³) | 4.4 | 7.5 |
| Acoustic velocity (m/s) | 5082 | 4160 |
| Characteristic acoustic impedance (×10⁶kg/m²s) | 25.0 | 31.2 |

Next, a comparative test was done on each measurement sample (Working Example A and Comparative Example A). Specifically, first, voltage was applied to the ultrasonic sensors of Working Example A and Comparative Example A. Then, ultrasonic waves were vertically irradiated (transmitted) onto the surface of the stainless-steel plate placed 20cm away from the ultrasonic sensors. The ultrasonic wave was a rectangular wave having an amplitude of 10Vp-p and a burst wave of 0.1ms. Also, the frequency was switched to multiple levels between 160kHz and 240kHz, and ultrasonic waves were irradiated at each of the switched frequencies.

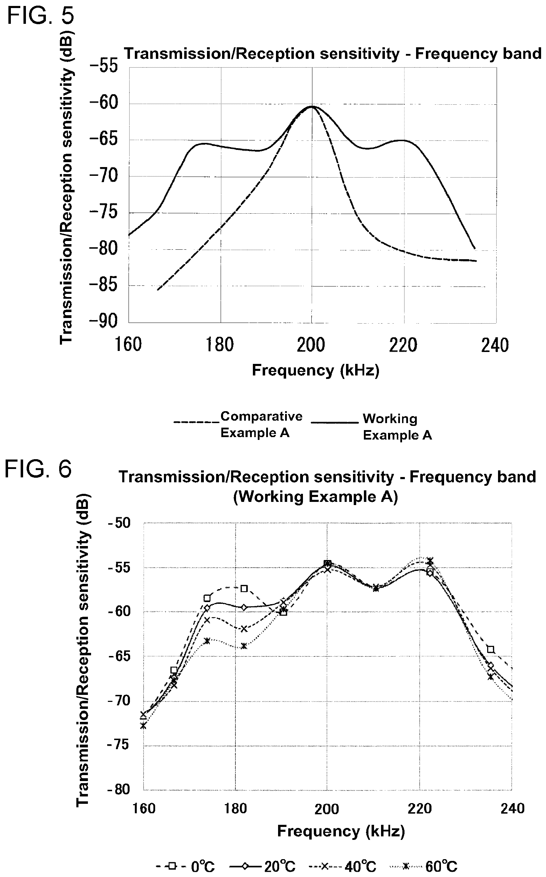

Then, the ultrasonic wave that was reflected onto the surface of the stainless steel plate was received by the ultrasonic sensor after a lapse of a predetermined time since being transmitted, and a voltage signal was generated at both ends (the front-side electrode layer and the rear-side electrode layer) of the ultrasonic sensor. Then, the voltage magnitude at the time of transmission and reception by the ultrasonic sensor was measured with an oscilloscope. Then, the maximum transmission/reception sensitivity, the frequency band, the lower-limit frequency f1 and the upper-limit frequency f2 were calculated based on the measurement. Next, the center-frequency fm and the frequency-bandwidth Δf were calculated based on the lower-limit frequency f1 and the upper-limit frequency f2 that were calculated by arithmetic processing. Further, the fractional-bandwidth Δf/fm was calculated based on the calculated center-frequency fm and frequency-bandwidth Δf. The transmission/reception sensitivity is a ratio of the reception-voltage magnitude V₂ to the transmission-voltage magnitude Vi and is calculated based on the formula of 20×log (V₂/V₁). The maximum transmission/reception sensitivity indicates the value at which the transmission/reception sensitivity became greatest within the range of 160 kHz to 240 kHz. The frequency band indicates the frequency range at which the transmission/reception sensitivity was reduced by 6dB from the maximum transmission/reception sensitivity. The lower-limit frequency f1 indicates the lower-limit frequency in the frequency band, and the upper-limit frequency f2 indicates the upper-limit frequency in the frequency band. The center-frequency fm indicates an intermediate value between the lower-limit frequency f1 and the upper-limit frequency f2 and is calculated from the formula (f1+f2)/2. The frequency-bandwidth Δf indicates a difference between the lower-limit frequency f1 and the upper-limit frequency f2. The fractional-bandwidth Δf/fm indicates a ratio between the frequency-bandwidth Δf and the center-frequency fm. FIG. 5 shows the results of Working Example A and Comparative Example A. FIG. 5 is a graph in which the vertical axis indicates transmission/reception sensitivity, and the horizontal axis indicates frequency.

As a result, as shown in FIG. 5 in Working Example A, in which the piezoelectric element is made of KNN-based ceramics, it was confirmed that the frequency of the ultrasonic wave, at the point at which the maximum transmission/reception sensitivity was calculated, is 200kHz. In Working Example A, it was confirmed that the maximum transmission/reception sensitivity is -61.0dB, that the frequency band is 173kHz or more and 223kHz or less, that the frequency bandwidth Δf is 50kHz, that the center frequency fm is 198kHz, and that the fractional bandwidth Δf/fm is 25%.

Further, as shown in FIG. 5 in Working Example A, it was confirmed that the waveform showing the transmission/reception sensitivity has three peaks of the transmission/reception sensitivity. Specifically, the waveform showing the transmission/reception sensitivity consists of a first peak at which the transmission/reception sensitivity becomes -61.0dB (maximum transmission/reception sensitivity) when the frequency is 200kHz, a second peak at which the transmission/reception sensitivity becomes -65.5dB, and a third peak at which the transmission/reception sensitivity becomes -65.0dB when the frequency is 210kHz. That is, it was confirmed that the waveform showing the transmission/reception sensitivity is made of peaks of which the second and third peaks, having a lower transmission/reception sensitivity, are arranged on both sides of the first peak, and that the sensitivity of these three peaks are equal to or higher than the predetermined transmission/reception sensitivity (e.g. -67.0dB). Then, it was also confirmed that there are three peaks, thus subsequently expanding the frequency band.

On the other hand, also in Comparative Example A in which the piezoelectric element is made of PZT ceramics, it was confirmed that the frequency of the ultrasonic wave, at the point where the maximum transmission/reception sensitivity was calculated, shows 200kHz. Moreover, in Comparative Example A, the maximum transmission/reception sensitivity is equivalent to that of Working Example A (-61.0dB), thus having the sensitivity equivalent to that of Working Example A. However, in Comparative Example A, it was confirmed that the frequency band was 194kHz or more and 206kHz or less; that the frequency-bandwidth Δf was 12kHz; that the center-frequency fm was 200kHz; and that the fractional-bandwidth Δf/fm was 6%. That is, it was confirmed that the frequency-bandwidth Δf and the fractional-bandwidth Δf/fm show values smaller than those of the Working Example A, so that the frequency band becomes narrow.

Further, in conducting the comparative test regarding Working Example A, the radial-resonance frequency f of the piezoelectric element and the acoustic velocity c of the longitudinal wave (ultrasonic wave) propagating in the acoustic-matching layer were measured. Then, based on the resonance frequency f and the acoustic velocity c, the value of the wavelength λ(=c/f) of the ultrasonic wave propagating in the acoustic-matching layer was calculated. Further, a comparative test was performed while gradually reducing the thickness t of the acoustic-matching layer, so as to confirm the relationship between the thickness t and the wavelength λ and the waveform indicating the transmission/reception sensitivity (see FIG. 5). As a result, when the thickness t becomes thinner than one fourth as much as the wavelength λ and becomes about 0.23 times as much as the wavelength λ (λ / 4-7.6%), it was confirmed that the number of peaks constituting the waveform that indicates the transmission/reception sensitivity became three.

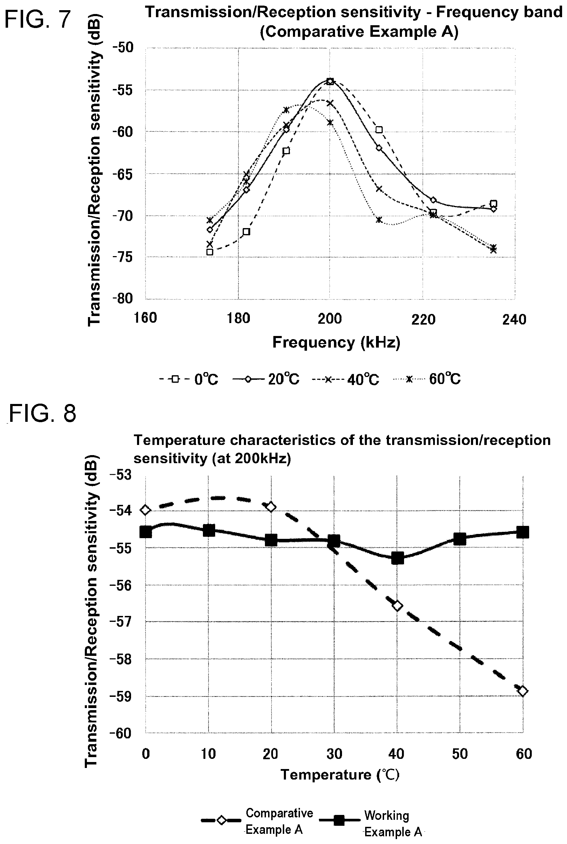

Next, the temperature characteristics of Working Example A and of Comparative Example A were evaluated. Two ultrasonic sensors were prepared per Working Example A and Comparative Example A. Both ultrasonic sensors were placed opposite each other at a distance of 15 cm in a thermostatic bath. Then, the temperature of the thermostatic bath was changed in the range of 0°C to 60°C, and the relationship between the frequency and the transmission/reception sensitivity was measured at the temperature of 0°C, 20°C, 40°C and 60°C. FIG. 6 shows the results of Working Example A, and FIG. 7 shows the results of Comparative Example A. As a result, in Working Example A, even if the temperature changes, it was confirmed that the transmission/reception sensitivity at 200kHz (frequency of the ultrasonic wave at the location where the maximum transmission/reception sensitivity is calculated) is substantially constant. This would be, because the frequency band is broad (frequency bandwidth Δf=50kHz) that makes the influence of the change in the resonance frequency due to the moderate temperature variation.

Furthermore, with the frequency of the ultrasonic wave being set at 200kHz, the temperature of the thermostatic bath is changed in the range of 0°C to 60 °C to measure the transmission/reception sensitivity of Working Example A at the temperatures of 0°C, 10°C, 20°C, 30°C, 40°C, 50°C and 60°C and to measure the transmission/reception sensitivity of Comparative Example A at the temperatures of 0°C, 20°C, 40°C and 60°C. FIG. 8 shows the results of Working Example A and Comparative Example A, confirming in Working Example A that the transmission/reception sensitivity is maintained virtually constant even if the temperature changes. On the other hand, it was confirmed in Comparative Example A that the transmission/reception sensitivity tends to decrease as the temperature increases.

In addition, a measurement sample was prepared as follows. In Working Example A in which the piezoelectric element is made of KNN-based ceramics, an ultrasonic sensor in which the dimensions of each part are changed was prepared and specified as Working Example B. Table 3 shows the dimensions of each part of Working Example B. Also, Working Example B has identical material characteristics to those of Working Example A (see Table 2), and the radial-resonance frequency of the piezoelectric element was 97 kHz. In Example B, the density of the acoustic-matching layer was 0.52g/cm³, and the acoustic velocity c of the longitudinal wave (ultrasonic wave) propagating in the acoustic matching layer was 2,569m/s. Therefore, the wavelength λ of the ultrasonic wave propagating in the acoustic matching layer was 26.5mm.

**Table 3**

| | Material of the piezoelectric element | Dimensions of the piezoelectric element | Dimensions of the matching layer |
|---|---|---|---|
| Working Example B | KNN-based ceramics | Outer diameter: 30.4mm Thickness: 3.0mm | Outer diameter: 30.4mm Thickness: (described in Table 4) |

Next, a comparative test was done on the measurement sample (Working Example B). Specifically, ultrasonic sensors manufactured by changing the thickness of the acoustic-matching layer were first prepared, and these were referred to as Working Examples B1 to B37. Table 4 shows Working Examples B1 to B37. Next, voltage was applied to the ultrasonic sensors of Working Examples B1 to B37, and ultrasonic waves were vertically irradiated (transmitted) onto the surface of the stainless-steel plate placed 0.9m away from the ultrasonic sensors. The ultrasonic wave was a rectangular wave having an amplitude of 100Vp-p to 200Vp-p and a burst wave of 0.1ms. Also, the frequency was switched to multiple levels between 65kHz and 150kHz, and ultrasonic waves were irradiated at each of the switched frequencies.

**Table 4**

| Working Example | Thickness of matching layer | | Deviation between t and λ /4 | Maximum transmission/ reception sensitivity | Center frequency | Bandwidth | Fractional bandwidth | Sensitivity : Good or Bad | Fractional bandwidth Good or Bad |
|---|---|---|---|---|---|---|---|---|---|
| | t | t/λ | | | fm | Δf | Δf/fm | | |
| | (mm) | | | (dB) | (kHz) | (kHz) | | | |
| B1 | 8.26 | 0.312 | 24.8% | -91.2 | 80.1 | 14.7 | 18.3% | ○ | ○ |
| B2 | 7.96 | 0.301 | 20.2% | -93.0 | 86.1 | 19.9 | 23.1% | △ | ⊚ |
| B3 | 7.91 | 0.299 | 19.5% | -91.9 | 83.4 | 16.1 | 19.3% | ○ | ○ |
| B4 | 7.85 | 0.296 | 18.6% | -90.9 | 82.6 | 14.6 | 17.7% | ○ | ○ |
| B5 | 7.81 | 0.295 | 18.0% | -91.1 | 83.8 | 16.6 | 19.8% | ○ | ○ |
| B6 | 7.75 | 0.293 | 17.0% | -90.5 | 82.1 | 13.3 | 16.2% | ○ | ○ |
| B7 | 7.70 | 0.291 | 16.3% | -91.0 | 87.2 | 23.0 | 26.4% | ○ | ⊚ |
| B8 | 7.63 | 0.288 | 15.2% | -91.2 | 87.4 | 23.1 | 26.5% | ○ | ⊚ |
| B9 | 7.56 | 0.285 | 14.2% | -92.0 | 88.6 | 25.4 | 28.7% | ○ | ⊚ |
| B10 | 7.45 | 0.281 | 12.5% | -91.6 | 88.6 | 24.5 | 27.7% | ○ | ⊚ |
| B11 | 7.39 | 0.279 | 11.6% | -91.7 | 89.4 | 25.4 | 28.4% | ○ | ⊚ |
| B12 | 7.35 | 0.278 | 11.0% | -91.9 | 89.9 | 25.6 | 28.5% | ○ | ⊚ |
| B13 | 7.23 | 0.273 | 9.2% | -91.7 | 91.2 | 25.7 | 28.1% | ○ | ⊚ |
| B14 | 7.15 | 0.270 | 8.0% | -90.8 | 92.5 | 22.6 | 24.5% | ○ | ⊚ |
| B15 | 7.07 | 0.267 | 6.8% | -85.4 | 98.9 | 9.6 | 9.7% | ⊚ | △ |
| B16 | 7.02 | 0.265 | 6.0% | -85.2 | 98.9 | 9.6 | 9.7% | ⊚ | △ |
| B17 | 6.96 | 0.263 | 5.1% | -85.2 | 99.2 | 9.9 | 10.0% | ⊚ | △ |
| B18 | 6.91 | 0.261 | 4.4% | -85.5 | 99.3 | 10.0 | 10.0% | ⊚ | △ |
| B19 | 6.86 | 0.259 | 3.6% | -85.2 | 99.4 | 10.0 | 10.1% | ⊚ | △ |
| B20 | 6.81 | 0.257 | 2.9% | -85.2 | 99.5 | 10.0 | 10.0% | ⊚ | △ |
| B21 | 6.76 | 0.255 | 2.1% | -85.2 | 99.6 | 9.9 | 9.9% | ⊚ | △ |
| B22 | 6.71 | 0.253 | 1.3% | -85.1 | 100.0 | 10.6 | 10.6% | ⊚ | △ |
| B23 | 6.66 | 0.251 | 0.6% | -85.3 | 100.1 | 10.0 | 10.0% | ⊚ | △ |
| B24 | 6.57 | 0.248 | -0.8% | -85.2 | 100.6 | 9.2 | 9.1% | ⊚ | △ |
| B25 | 6.41 | 0.242 | -3.2% | -86.6 | 105.6 | 18.5 | 17.5% | ⊚ | ○ |
| B26 | 6.33 | 0.239 | -4.4% | -86.8 | 106.4 | 19.4 | 18.2% | ⊚ | ○ |
| B27 | 6.27 | 0.237 | -5.3% | -87.9 | 107.9 | 21.4 | 19.8% | ⊚ | ○ |
| B28 | 6.14 | 0.232 | -7.3% | -89.9 | 111.4 | 31.0 | 27.8% | ○ | ⊚ |
| B29 | 6.05 | 0.228 | -8.6% | -89.9 | 109.3 | 28.5 | 26.1% | ○ | ⊚ |
| B30 | 5.92 | 0.224 | -10.6% | -89.9 | 109.5 | 28.3 | 25.8% | ○ | ⊚ |
| B31 | 5.76 | 0.217 | -13.0% | -89.9 | 116.7 | 20.0 | 17.1% | ○ | ○ |
| B32 | 5.56 | 0.210 | -16.0% | -90.2 | 121.3 | 19.3 | 15.9% | ○ | ○ |
| B33 | 5.36 | 0.202 | -19.0% | -91.1 | 124.1 | 13.6 | 11.0% | ○ | △ |
| B34 | 5.16 | 0.195 | -22.1% | -93.7 | 128.0 | 14.7 | 11.5% | △ | △ |
| B35 | 4.86 | 0.184 | -26.6% | -97.9 | 76.2 | 8.2 | 10.7% | × | △ |
| B36 | 4.66 | 0.176 | -29.6% | -103.7 | 77.4 | 7.6 | 9.9% | × | △ |
| B37 | 4.36 | 0.165 | -34.2% | -103.5 | 79.9 | 8.8 | 11.0% | × | △ |

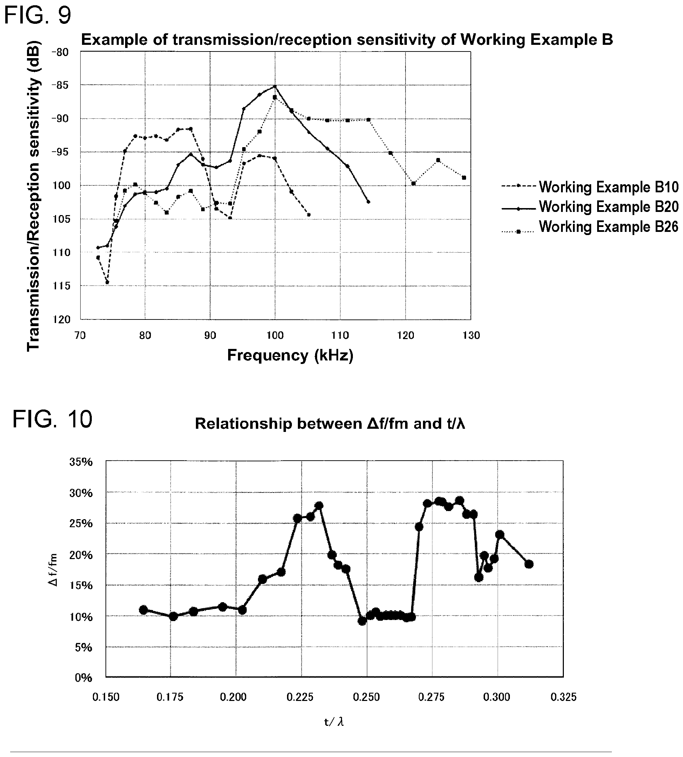

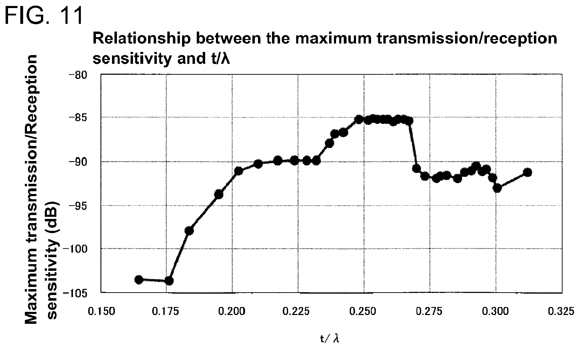

Then, the ultrasonic wave that was reflected onto the surface of the stainless steel plate was received by the ultrasonic sensor after the lapse of a predetermined time since being transmitted, and a voltage signal was generated at both ends (the front-side electrode layer and the rear-side electrode layer) of the ultrasonic sensor. Then, the voltage magnitude at the time of transmission and reception by the ultrasonic sensor was measured with an oscilloscope, and the maximum transmission/reception sensitivity, the frequency band, the lower-limit frequency f1 and the upper-limit frequency f2 were calculated based on the results. Next, the center-frequency fm and the frequency-bandwidth Δf were calculated based on the lower-limit frequency f1 and the upper-limit frequency f2 calculated by arithmetic processing. Further, a fractional bandwidth Δf/fm was calculated based on the calculated center-frequency fm and on the frequency-bandwidth Δf. Further, the ratio (=t/λ) between the wavelength λ (26.5mm) of the ultrasonic wave propagating in the acoustic-matching layer and the thickness t of the acoustic-matching layer was calculated. Also, the deviation (=(t-λ/4)/(λ/4) of the thickness t from λ/4 was calculated. FIG. 10 shows the relationship between the fractional bandwidth Δf/fm and t/λ. FIG. 11 shows the relationship between the maximum transmission/reception sensitivity and t/λ.

As a result, it was confirmed that in all of Working Examples B1 to B37, the fractional bandwidth Δf/fm is 9% or more, that is, broader compared to Comparative Example A in which the fractional bandwidth Δf/fm is 6%. However, it was also confirmed that in Working Examples B23 and B24 in which the thickness t is within the range of λ/4±1%, although the maximum transmission/reception sensitivity is high, the fractional bandwidth Δf/fm is relatively narrow among Working Examples B1 to B37, that is, about 9 to 10%. On the other hand, it was confirmed that in Working Examples B7 to B14 in which the thickness t is 8.0 to 16.3% thicker than λ/4, the fractional bandwidth Δf/fm is relatively broad, that is, 24% or more. It was also confirmed that in Examples B28 to B30 in which the thickness t is 7.3 to 10.6% less than λ/4, the fractional bandwidth Δf/fm is relatively broader, that is, 25% or more. Therefore, when selecting the thickness t of the acoustic-matching layer so that the fractional bandwidth Δf/fm is 24% or more, that is, when selecting Working Examples B7 to B14 in which the thickness t is greater by 8.0 to 16.3% with respect to λ/4 or Working Examples B28 to B30 in which the thickness t is 7.3 to 10.6% less than λ/4, the ultrasonic sensor having a broader frequency range can be realized. It was also confirmed that in Working Examples B7 to B14 and in B28 to B30 that the maximum transmission/reception sensitivity is relatively good (i.e. -92.0dB or more). Also, when selecting Working Examples B7 to B14 in which the thickness t is greater by 8.0 to 16.3% than λ/4, the acoustic-matching layer becomes thicker than that of Working Example B28 to B30, thus making it easier to secure the strength of the ultrasonic sensor. On the other hand, when selecting Working Examples B28 to B30 in which the thickness t is less by 7.3 to 10.6% with respect to λ/4, the acoustic-matching layer becomes thinner than that of Working Examples B7 to B14, thus making it possible to reduce the size and weight of the ultrasonic sensor.

Further, it was confirmed that in Working Examples B15 to B27 in which the thickness t is -5.3% to 6.8% of λ/4, the maximum transmission/reception sensitivity is relatively high (-87.9% or more). However, it was also confirmed that in Examples B15 to B24 in which the thickness t is -0.8 to 6.8% of λ/4, the maximum transmission/reception sensitivity is high but that the fractional bandwidth Δf/fm is relatively narrow among Working Examples B1 to B37, about 9 to 10%. On the other hand, it was confirmed that in Working Examples B25 to B27 in which the thickness t is -5.3% to -3.2% of λ/4, the fractional bandwidth Δf/fm is relatively broad, that is, 17.5% or more. Therefore, it was confirmed that when selecting Working Examples B25 to B27 in which the thickness t is -5.3% to -3.2% of λ/4, the maximum transmission/reception sensitivity is obtained with a relatively good frequency band, thus realizing an ultrasonic sensor having a high level of maximum transmission/reception sensitivity.

Next, a comparative test was performed on Working Examples B10, B20 and B26 arbitrarily selected from Working Examples B1 to B37. Specifically, first, voltage was applied to the ultrasonic sensors of Working Examples B10, B20 and B26, and ultrasonic waves were vertically irradiated onto to the surface of the stainless-steel plate placed in a position 0.9m away from the ultrasonic sensors. Further, the frequency was switched to multiple levels between 70kHz and 130kHz, and ultrasonic waves were irradiated at each level of the switched frequencies. The ultrasonic waves reflected onto the surface of the stainless-steel plate were received by the ultrasonic sensor after a lapse of a predetermined time since being transmitted.

Then, the voltage magnitudes at the time of transmission and reception of the ultrasonic sensor were measured with an oscilloscope, and the transmission/reception sensitivity and the maximum transmission/reception sensitivity were calculated based on the measurement results. Also, the maximum transmission/reception sensitivity shows a value of which the transmission/reception sensitivity becomes maximum within the range of 70kHz to 130kHz. FIG. 9 shows the results of Working Examples B10, B20 and B26. FIG. 9 is also a graph in which the vertical axis shows transmission/reception sensitivity and the horizontal axis shows frequency.

As a result, as shown in FIG. 9, it was confirmed that in Working Example B20, although the transmission/reception sensitivity is maximized when the frequency of the ultrasonic wave is around 100kHz, the transmission/reception sensitivity decreases drastically (that is, the frequency band becomes narrow), with the frequency changing only a few kHz from 100kHz. On the other hand, it was confirmed that in Working Example B10, the transmission/reception sensitivity is maximized when the frequency of the ultrasonic wave is around 88kHz, but that the transmission/reception sensitivity is hardly reduced within the frequency range of 78kHz to 88kHz. It was also confirmed that in Example B26, the transmission/reception sensitivity is maximized when the frequency of the ultrasonic wave is around 100kHz, but that the transmission/reception sensitivity is hardly reduced within the frequency range of 100kHz to 115kHz.

Therefore, according to the embodiments of this invention, the following effects can be realized.
(1) According to the ultrasonic sensors 11 and 12 as the embodiment of this invention, the mechanical-quality factor Qm of the piezoelectric element 13 is as low as 50 or less, which makes the oscillation of the piezoelectric element 13 to stop immediately after the transmission of the ultrasonic wave W1. In this case, the piezoelectric element 13 does not oscillate at the time of receiving the ultrasonic wave W1, thus making it possible to receive accurately the incident-ultrasonic wave W1. Also, it is possible to shorten the time until the next ultrasonic wave W1 is transmitted. Moreover, since the ultrasonic wave W1 having a wide range of frequencies can be received, a stable operation can be performed even when the periodic environment, such as temperature, changes. The frequency element Np in the radial direction of the broadband-piezoelectric element 13 is 2800 Hz · m or more, which is greater than the frequency constant Np (2095 Hz · m) in the case that the piezoelectric element 13 is made of lead-zirconate titanate (PZT). In this case, in order to output the ultrasonic wave W1 having a desired frequency, it is necessary to make the outer diameter of the piezoelectric element 13 greater than that in the case that the piezoelectric element 13 is made of lead-zirconate titanate. As a result, the area of the acoustic-emitting surface (front surface 15) of the piezoelectric element 13 increases, thus making it possible to improve the transmission/reception sensitivity of the ultrasonic sensors 11 and 12. In addition, as the area of the front surface 15 increases, the directivity of the ultrasonic wave W1 output from the piezoelectric element 13 also increases. From the above, if the ultrasonic sensors 11 and 12 are used, for example, for digital-signal processing technology (CHIRP transmission and the like) that has been developed in recent years, replacement with PZT will be advanced, which is expected to reduce environmental pollution and adverse health effects.
(2) By the way, in the piezoelectric element 13 that oscillates in the radial direction, as the embodiment of this invention, if the thickness t of the acoustic matching layer 14 is set at one fourth of the wavelength λ of the ultrasonic wave W1 propagating within the acoustic-matching layer 14, then the phase of the transmitted wave is matched with that of the reflected wave, while the ultrasonic wave W1 having the resonance frequency f propagates within the acoustic-matching layer 14, thus the transmission/ reception sensitivity becomes optimal (maximum) at center frequency fm. However, of the embodiment of this invention, the thickness t of the acoustic-matching layer 14 is within the range of λ/4±20% and is shifted more than 1% from λ/4. As a result, the frequency band of the ultrasonic sensors 11 and 12 is broader than that in the case where the piezoelectric element 13 is made of lead-zirconate titanate. Further, according to the embodiment of this invention, as well as shifting the thickness t of the acoustic matching layer 14 from λ/4, the mechanical-quality factor Qm of the piezoelectric element 13 is low and the characteristic-acoustic impedance is also low due to the low density of the piezoelectric element 13, which all contribute in making the bandwidth of the ultrasonic sensors 11 and 12 wider.
(3) As the prior art, described in Patent Document 6, regarding an ultrasonic sensor including a piezoelectric element and a cylindrical-acoustic matching layer, a tapered portion (surface C) is formed at the end of the top surface of the acoustic-matching layer. As such, a technique, by which three resonance frequency peaks are generated (see FIGS. 2 to 4 of Reference 6), is proposed. However, the chamfering operation is required, which causes the problem of increasing the cost of manufacturing the ultrasonic sensor. In addition, the formation of the tapered portion reduces the area of the top surface that is the oscillation surface, so that the transmission/reception sensitivity of the ultrasonic sensor is reduced, and the directivity of the ultrasonic wave output from the piezoelectric element is reduced. Also, there is another problem: the ultrasonic waves are diffused from the tapered portion, and such diffused ultrasonic waves become noise.
   On the other hand, according to the embodiment of this invention, the disc-shaped acoustic-matching layer 14 is joined to the piezoelectric element 13 made of alkali-niobate-based ceramic, which generates three peaks in the waveform indicating the transmission/reception sensitivity as shown in the graph of the vertical axis indicating the transmission/reception sensitivity and of the horizontal axis indicating the frequency (see FIG. 5). In this case, it is unnecessary to form the tapered portion, thus making it possible to solve the above-mentioned problem caused by the tapered portion. Also, each peak frequency is different respectively, thus subsequently broadening the frequency band indicating the frequency range at the transmission/reception sensitivity reduced by 6dB from the maximum transmission/reception sensitivity.
(4) In this embodiment, the density of the piezoelectric element 13 is 3.96g/cm³ or more and 4.84g/cm³ or less and is less than the density (7.5g/cm³) in the case that the piezoelectric element 13 is made of lead-zirconate titanate. As a result, the characteristic-acoustic impedance of the piezoelectric element 13 is reduced, so that the ultrasonic wave W1 irradiated from the piezoelectric element 13 is easily transmitted to the acoustic-matching layer 14. Moreover, the acoustic-matching layer 14 is made of a material in which a glass balloon is mixed with an epoxy resin and has a specific gravity of 0.5 or less. As such, the characteristic acoustic impedance of the acoustic matching layer 14 decreases, so that the ultrasonic wave W1 propagating in the acoustic-matching layer 14 is easily irradiated into the air. That is, the ultrasonic wave W1 easily propagates in the piezoelectric element 13 and in the acoustic-matching layer 14, thus further increasing the transmission/reception sensitivity of the ultrasonic sensors 11 and 12.
(5) According to the embodiment of this invention, an alkali-niobate-based piezoelectric element 13, having a Curie temperature Tc as high as 330°C or more and a piezoelectric constant d₃₃ of 250pC/N or more, is used. When the ultrasonic sensors 11 and 12 are configured by using such a piezoelectric element 13, the ultrasonic waves W1 can be transmitted and received efficiently, so that the product reliability of the ultrasonic-sensor system 1 can be sufficiently secured.
(6) According to the ultrasonic sensors 11 and 12 as the embodiment of this invention, the piezoelectric element 13 is made of lead-free alkali-niobate ceramics. In addition, soldering is done using lead-free solder, so that the lead wires 31 and 32 are connected to the electrode layers (the front-side electrode layer and the rear-side electrode layer) of the piezoelectric element 13, thus connecting the lead wires 31 and 32 to the cable 33. As a result, the ultrasonic sensors 11 and 12 are completely lead-free, so that adverse effects on the environment can be avoided when the ultrasonic sensors 11 and 12 are disposed of.

Also, the embodiments of this invention can be further modified as follows.
- Regarding the ultrasonic sensors 11 and 12 above as the embodiment of this invention, the piezoelectric element 13 made of KNN-based ceramics is used, but the piezoelectric element 13 may be made of other alkali-niobate-based ceramics. For example, the piezoelectric element 13 may include a crystalline phase having a perovskite structure and may be a composition represented by the following composition formula (2).

   {Liₓ (K_{1-y}Na_{y}) ₁₋ₓ} ₐ (Nb_{1-z-w}Ta_{z}Sb_{w}) O₃ ··· (2)

However, in the above composition formula (2), the compositions having the range of 0.90≦a≦1.2, 0.02≦x≦0.2, 0.2≦y≦0.8, 0≦z≦0.5, 0≦w≦0.2 are used for the piezoelectric elements 13. Also, in the above composition formula (2), the piezoelectric element 13 may be manufactured by adding a metallic element such as Bi, Fe or the like as additives.
- Regarding the above embodiment of this invention, the waveform showing the transmission/reception sensitivity has three peaks of the transmission/reception sensitivity (see FIG. 5). However, the waveform showing the transmission/reception sensitivity may have two peaks, or it may have four or more peaks.

Regarding the ultrasonic sensors 11 and 12 as the above embodiment of this invention, the acoustic-matching layer 14, made of a material obtained by mixing a hollow glass balloon with epoxy resin, is used, but the material of the acoustic-matching layer 14 is not particularly limited to this. It is also possible to use, for example, an acoustic-matching layer made of rubber mixed with hollow-glass beads or plastic beads; an acoustic-matching layer made of a plastic foam having closed cells such as foamed polyurethane, styrene foam; an acoustic-matching layer made of an alumina-porous material or the like. In addition, the acoustic-matching layer does not necessarily include the above-mentioned hollow material or air bubbles. In this case, materials for forming the acoustic-matching layer include e.g. a resin material such as an epoxy resin, an ABS resin or the like.
- The ultrasonic sensors 11 and 12 of the above embodiment of this invention have a structure having only one acoustic-matching layer 14. It is possible to have a different structure in which a plurality of acoustic-matching layers 14 are laminated. In this case, in at least one acoustic-matching layer 14, when the wavelength of the ultrasonic wave W1 propagating in the acoustic-matching layer 14 is represented by λ, and the thickness of the acoustic-matching layer 14 is represented by t, the relationship of t=λ/4 should be preferably satisfied. Further, to increase the bandwidth, the thickness t is preferably in the range of λ/4±20% and out of the range of λ/4±1%.

If the acoustic-matching layer 14 is made of multiple layers, then it is preferable that the characteristic-acoustic impedance of each layer of the acoustic-matching layer 14 be gradually reduced, for example, as the distance from the piezoelectric element 13 being far, thus making it possible to increase the transmittance of the ultrasonic wave W1 at the interface between the acoustic-matching layer 14 and the piezoelectric element 13. Also, when the values of the characteristic-acoustic impedances of the adjacent acoustic-matching layers 14 are substantially close (for example, when the difference between the characteristic-acoustic impedances is within about 10%), they can be considered as one matching layer, and the thickness of the matching layer can also be determined based on the average value of the wavelength of the ultrasonic wave W1 propagating within the matching layer.
- Regarding the ultrasonic sensors 11 and 12 as the above embodiment of this invention, the acoustic-matching layer 14 that is adhered to the piezoelectric element 13 is of a disk shape but is not limited to this. For example, it may be a frame-shaped (ring-shaped) acoustic-matching layer having a through-hole in the center or a lattice-shaped acoustic-matching layer having multiple through-holes. Furthermore, the acoustic-matching layer may be formed in a polygonal-plate shape such as a triangle, a quadrangle or the like.
- In the above embodiment, the case 20 in which the piezoelectric element 13 is placed is formed using aluminum. However, it is possible to form the case 20 by using another metallic material such as stainless steel or the like. It is also possible to form the case 20 by using a resin material such as an ABS resin (acrylonitrile-butadiene-styrene resin) or an epoxy resin or the like. Considering the strength and workability, it is preferable to form case 20 by using aluminum.
- Regarding the above embodiment of this invention, the second ends of the lead wires 31 and 32, which are connected to the electrode layers (the front-side electrode layer and the rear-side electrode layer) of the piezoelectric element 13, are connected to the cable 33 made of a single-core shielded wire, and such a cable 33 connected to the lead wires 31 and 32 is drawn out of the case 20. However, it is not limited to this structure. For example, it is also possible to connect the second ends of both lead wires 31 and 32 to terminal pins, respectively, and to draw both pins out of the case 20. It is further possible to draw the second ends themselves of both lead wires 31 and 32 out of the case 20.
- The acoustic-absorbing material of the embodiment of this invention is a sponge in which pores are dispersedly arranged in a resin material. However, it is also possible to use the acoustic-absorbing material of a resin material or rubber containing particles or fibers made of metal or ceramic. Regarding the space formed by the case 20 by the acoustic-matching layer 14 and by the divider 24, it is further possible to let air into the space 20 to act as an acoustic-absorbing material without having to fill an acoustic-absorbing material into the space. As such, an acoustic-absorbing material can be omitted, thus making it possible to reduce the cost of manufacturing the ultrasonic sensors 11 and 12. However, it is preferable to use a sponge an acoustic-absorbing material to reduce reverberation effectively and to reduce costs.
- The ultrasonic sensors 11 and 12, according to the above embodiment of this invention, have been used as an airborne sensor that detects the presence or absence of an obstacle S1 by irradiating the ultrasonic waves W1 into the air. However, it is not limited to this. Specifically, it is possible to use the ultrasonic sensors 11 and 12 as an airborne sensor for measuring a distance in the air. Also, the ultrasonic sensors 11 and 12 can be used as an air-bubble-detection sensor that measures the attenuation rate of ultrasonic waves propagating in a liquid and determines the presence or absence of air bubbles based on the attenuation rate; or used as an AE sensor that detects an AE wave for an ultrasonic test; or as an ultrasonic flowmeter that measures a gas-flow rate based on the difference in propagation time of ultrasonic waves transmitted and received between a pair of sensors or the like. Besides the aforementioned applications, it is also possible to use the ultrasonic sensors 11 and 12 as the knocking sensor of an engine, an actuator or the like.

### Description of the reference numerals

11: First ultrasonic sensor as the ultrasonic sensor
12: Second ultrasonic sensor as the ultrasonic sensor
13: Piezoelectric element
14: Acoustic-matching layer
20: Case
t: Thickness of the acoustic-matching layer
W1: Ultrasonic wave

## Claims

1. An ultrasonic sensor (11, 12) comprising:
a disk-shaped piezoelectric element (13) that transmits and receives ultrasonic waves, and an acoustic-matching layer (14), with the piezoelectric element being housed in a case (20) and fixed,
**characterized in that** the piezoelectric element (13) is {Liₓ (K_{1-y}Na_{y}) ₁₋ₓ} (Nb_{1-z}Sb_{z}) O₃ having a composition including Bi (bismuth) and Fe (iron) of a metallic element as additives, satisfying the range of 0.03≦x≦0.045, 0.5≦y≦0.58, 0. 03≦z≦0.045, wherein the mechanical-quality factor Qm is 50 or less, the radial-frequency constant Np is 2800Hz·m or more, and the piezoelectric constant d₃₃ is 250pC/N or more, and wherein the acoustic-matching layer (14) has an outer-diameter dimension equal to or greater than the outer-diameter dimension of the piezoelectric element (13); and
further **characterized in that** when the radial-resonance frequency of the piezoelectric element (13) is represented as f, when the acoustic velocity of a longitudinal wave propagating within the acoustic-matching layer (14) is represented as c, when the wavelength of the ultrasonic wave propagating within the acoustic-matching layer (14) is represented as λ, when the thickness of the acoustic-matching layer (14) is represented as t, then the relationship of λ=c/f is satisfied, as well as t=λ/4±20%, and t/λ is between 0.210 and 0.242 or between 0.270 and 0.299, and **characterized in that**
when a frequency range at the transmission/reception sensitivity that is reduced by 6dB from the maximum transmission/reception sensitivity is the frequency band, when a lower-limit frequency in the frequency band is the lower-limit frequency, when an upper-limit frequency in the frequency band is the upper-limit frequency, when an intermediate value between the lower-limit frequency and the upper-limit frequency is the center frequency fm, when the difference between the lower-limit frequency and the upper-limit frequency is the frequency bandwidth Δf, and when the ratio between the bandwidth Δf and the center-frequency fm is the fractional bandwidth Δf/fm, then the fractional bandwidth Δf/fm is 15% or more.

2. An ultrasonic sensor (11, 12) comprising:
a disk-shaped piezoelectric element (13) that transmits and receives ultrasonic waves, and an acoustic-matching layer (14), with the piezoelectric element being housed in a case (20) and fixed,
**characterized in that** the piezoelectric element (13) is {Liₓ(K_{1-y}Na_{y})₁₋ₓ}ₐ(Nb_{1-z-w}Ta_{z}Sb_{w})O₃ satisfying the range of 0.90≦a≦1.2, 0.02≦x≦0.2, 0. 2≦y≦0.8, 0≦z≦0.5, 0. 0≦w≦0.2 wherein the mechanical-quality factor Qm is 50 or less, the radial-frequency constant Np is 2800Hz·m or more, and the piezoelectric constant d33 is 250pC/N or more, and wherein the acoustic-matching layer (14) has an outer-diameter dimension equal to or greater than the outer-diameter dimension of the piezoelectric element (13); and
further **characterized in that** when the radial-resonance frequency of the piezoelectric element (13) is represented as f, when the acoustic velocity of a longitudinal wave propagating within the acoustic-matching layer (14) is represented as c, when the wavelength of the ultrasonic wave propagating within the acoustic-matching layer (14) is represented as λ, when the thickness of the acoustic-matching layer (14) is represented as t, then the relationship of λ=c/f is satisfied, as well as t=λ/4±20%, and t/λ is between 0.210 and 0.242 or between 0.270 and 0.299, and **characterized in that**
when a frequency range at the transmission/reception sensitivity that is reduced by 6dB from the maximum transmission/reception sensitivity is the frequency band, when a lower-limit frequency in the frequency band is the lower-limit frequency, when an upper-limit frequency in the frequency band is the upper-limit frequency, when an intermediate value between the lower-limit frequency and the upper-limit frequency is the center frequency fm, when the difference between the lower-limit frequency and the upper-limit frequency is the frequency bandwidth Δf, and when the ratio between the bandwidth Δf and the center-frequency fm is the fractional bandwidth Δf/fm, then the fractional bandwidth Δf/fm is 15% or more.

3. An ultrasonic sensor (11, 12), according to Claim 1 or 2, **characterized in that** the thickness of the acoustic-matching layer (14) is from λ/4-20% to λ/4-1% or from λ/4+1% to λ/4+20% .

4. An ultrasonic sensor (11, 12), according to any one of claims 1-3, **characterized in that** the piezoelectric element (13) has a density of 4.4 g/cm³± 10%.

## Patentansprüche

1. Ultraschallsensor (11, 12), der Folgendes umfasst:
ein scheibenförmiges piezoelektrisches Element (13), das Ultraschallwellen überträgt und empfängt, und eine akustische Anpassungsschicht (14), wobei das piezoelektrische Element in einem Gehäuse (20) untergebracht und befestigt ist,
**dadurch gekennzeichnet, dass** das piezoelektrische Element (13) {Liₓ (K_{1-y}Na_{y}) ₁₋ₓ} (Nb_{1-z}Sbz)O₃ eine Zusammensetzung aufweist, die Bi (Wismut) und Fe (Eisen) eines metallischen Elements als Zusatzstoffe beinhaltet, die den Bereich von 0,03 ≦x ≦ 0,045, 0,5 ≦ y ≦ 0,58, 0,03 ≦ z ≦ 0,045 erfüllen, wobei der mechanische Qualitätsfaktor Qm 50 oder weniger beträgt, die Radialfrequenzkonstante Np 2800 Hz·m oder mehr beträgt, und die piezoelektrische Konstante d₃₃ 250 pC/N oder mehr beträgt, und wobei die akustische Anpassungsschicht (14) eine Außendurchmesserabmessung aufweist, die gleich oder größer als die Außendurchmesserabmessung des piezoelektrischen Elements (13) ist; und
ferner **dadurch gekennzeichnet, dass**, wenn die Radialresonanzfrequenz des piezoelektrischen Elements (13) als f dargestellt ist, wenn die Schallgeschwindigkeit einer sich innerhalb der akustischen Anpassungsschicht (14) ausbreitenden Longitudinalwelle als c dargestellt ist, wenn die Wellenlänge der Ultraschallwelle, die sich innerhalb der akustischen Anpassungsschicht (14) ausbreitet, als λ dargestellt ist, wenn die Dicke der akustischen Anpassungsschicht (14) als t dargestellt ist, die Beziehung λ = c/f ebenso wie t = λ/4 ± 20 % erfüllt ist, und t/λ zwischen 0,210 und 0,242 oder zwischen 0,270 und 0,299 liegt, und **dadurch gekennzeichnet, dass**
wenn ein Frequenzbereich bei der Übertrangungs-/Empfangsempfindlichkeit, die um 6 dB von der maximalen Übertragungs-/Empfangsempfindlichkeit reduziert ist, das Frequenzband ist, wenn eine untere Grenzfrequenz in dem Frequenzband die untere Grenzfrequenz ist, wenn eine obere Grenzfrequenz in dem Frequenzband die obere Grenzfrequenz ist, wenn ein Zwischenwert zwischen der unteren Grenzfrequenz und der oberen Grenzfrequenz die Mittenfrequenz fm ist, wenn die Differenz zwischen der unteren Grenzfrequenz und der oberen Grenzfrequenz die Frequenzbandbreite Δf ist, und wenn das Verhältnis zwischen der Bandbreite Δf und der Mittenfrequenz fm die normierte Bandbreite Δf/fm ist, die normierte Bandbreite Δf/fm dann 15 % oder mehr ist.

2. Ultraschallsensor (11, 12), der Folgendes umfasst:
ein scheibenförmiges piezoelektrisches Element (13), das Ultraschallwellen überträgt und empfängt, und eine akustische Anpassungsschicht (14), wobei das piezoelektrische Element in einem Gehäuse (20) untergebracht und befestigt ist,
**dadurch gekennzeichnet, dass** das piezoelektrische Element (13) {Liₓ(K_{1-y}Nay)₁₋ₓ}ₐ(Nb_{1-z-w}Ta_{z}Sb_{w})O₃ ist, das den Bereich von 0,90 ≦ a ≦ 1,2, 0,02 ≦ x ≦ 0,2, 0, 2 ≦ y ≦ 0,8, 0 ≦ z ≦ 0,5, 0 erfüllt.
0 ≦ w ≦ 0,2, wobei der mechanische Qualitätsfaktor Qm 50 oder weniger beträgt, die Radialfrequenzkonstante Np 2800 Hz·m oder mehr beträgt, und die piezoelektrische Konstante d₃₃ 250 pC/N oder mehr beträgt, und wobei die akustische Anpassungsschicht (14) eine Außendurchmesserabmessung gleich oder größer als die Außendurchmesserabmessung des piezoelektrischen Elements (13) aufweist; und
ferner **dadurch gekennzeichnet, dass**, wenn die Radialresonanzfrequenz des piezoelektrischen Elements (13) als f dargestellt ist, wenn die Schallgeschwindigkeit einer sich innerhalb der akustischen Anpassungsschicht (14) ausbreitenden Longitudinalwelle als c dargestellt ist, wenn die Wellenlänge der Ultraschallwelle, die sich innerhalb der akustischen Anpassungsschicht (14) ausbreitet, als λ dargestellt ist, wenn die Dicke der akustischen Anpassungsschicht (14) als t dargestellt ist, die Beziehung λ = c/f ebenso wie t = λ/4 ± 20 % erfüllt ist, und t/λ zwischen 0,210 und 0,242 oder zwischen 0,270 und 0,299 liegt, und **dadurch gekennzeichnet, dass**
wenn ein Frequenzbereich bei der Übertrangungs-/Empfangsempfindlichkeit, die um 6 dB von der maximalen Übertragungs-/Empfangsempfindlichkeit reduziert ist, das Frequenzband ist, wenn eine untere Grenzfrequenz in dem Frequenzband die untere Grenzfrequenz ist, wenn eine obere Grenzfrequenz in dem Frequenzband die obere Grenzfrequenz ist, wenn ein Zwischenwert zwischen der unteren Grenzfrequenz und der oberen Grenzfrequenz die Mittenfrequenz fm ist, wenn die Differenz zwischen der unteren Grenzfrequenz und der oberen Grenzfrequenz die Frequenzbandbreite Δf ist, und wenn das Verhältnis zwischen der Bandbreite Δf und der Mittenfrequenz fm die normierte Bandbreite Δf/fm ist, die normierte Bandbreite Δf/fm dann 15 % oder mehr ist.

3. Ultraschallsensor (11, 12) nach Anspruch 1 oder 2, **dadurch gekennzeichnet, dass** die Dicke der akustischen Anpassungsschicht (14) λ/4 - 20 % bis λ/4 - 1 % oder λ/4 + 1 % bis λ/4 + 20 % beträgt.

4. Ultraschallsensor (11, 12) nach einem der Ansprüche 1 bis 3, **dadurch gekennzeichnet, dass** das piezoelektrische Element (13) eine Dichte von 4,4 g/cm³ ± 10 % aufweist.

## Revendications

1. Capteur ultrasonore (11, 12), comprenant :
un élément piézoélectrique (13) en forme de disque qui émet et reçoit des ondes ultrasonores, et une couche d'adaptation acoustique (14), l'élément piézoélectrique étant logé dans un boîtier (20) et fixé,
**caractérisé en ce que** l'élément piézoélectrique (13) est {Liₓ (K_{1-y}Na_{y}) ₁₋ₓ} (Nb_{1-z}Sb_{z})O₃ présentant une composition comprenant du Bi (bismuth) et du Fe (fer) d'un élément métallique en tant qu'additifs, satisfaisant la plage de 0,03 ≦x ≦0,045, 0,5 ≦y ≦ 0,58, 0, 03 ≦ z ≦ 0,045, dans lequel le facteur de qualité mécanique Qm est inférieur ou égal à 50, la constante de fréquence radiale Np est supérieure ou égale à 2800Hz·m, et la constante piézoélectrique d₃₃ est supérieure ou égale à 250pC/N, et dans lequel la couche d'adaptation acoustique (14) présente une dimension de diamètre externe supérieure ou égale à la dimension de diamètre externe de l'élément piézoélectrique (13) ; et
**caractérisé en outre en ce que**, lorsque la fréquence de résonance radiale de l'élément piézoélectrique (13) est représentée par f, lorsque la vitesse acoustique d'une onde longitudinale se propageant dans la couche d'adaptation acoustique (14) est représentée par c, lorsque la longueur d'onde de l'onde ultrasonore se propageant dans la couche d'adaptation acoustique (14) est représentée par λ, lorsque l'épaisseur de la couche d'adaptation acoustique (14) est représentée par t, alors la relation λ = c/f est satisfaite, ainsi que t = λ/4 ± 20 % , et t/λ est compris entre 0,210 et 0,242 ou entre 0,270 et 0,299, et **caractérisé en ce que**,
lorsqu'une plage de fréquence à la sensibilité d'émission / de réception qui est réduite de 6 dB par rapport à la sensibilité maximale d'émission / de réception est la bande de fréquences, lorsqu'une fréquence limite inférieure dans la bande de fréquences est la fréquence limite inférieure, lorsqu'une fréquence limite supérieure dans la bande de fréquences est la fréquence limite supérieure, lorsqu'une valeur intermédiaire entre la fréquence limite inférieure et la fréquence limite supérieure est la fréquence centrale fm, lorsque la différence entre la fréquence limite inférieure et la fréquence limite supérieure est la largeur de bande de fréquence Δf, et lorsque le rapport entre la largeur de bande Δf et la fréquence centrale fm est la largeur de bande fractionnaire Δf/fm, alors la largeur de bande fractionnaire Δf/fm est supérieure ou égale à 15 %.

2. Capteur ultrasonore (11, 12), comprenant :
un élément piézoélectrique (13) en forme de disque qui émet et reçoit des ondes ultrasonores, et une couche d'adaptation acoustique (14), l'élément piézoélectrique étant logé dans un boîtier (20) et fixé,
**caractérisé en ce que** l'élément piézoélectrique (13) est {Liₓ(K_{1-y}Na_{y})₁₋ₓ}ₐ(Nb_{1-z-w}Ta_{z}Sb_{w})O₃ satisfaisant la plage de 0,90 ≦ a ≦ 1,2, 0,02 ≦x ≦0,2, 0, 2 ≦ y ≦ 0,8, 0 ≦ z ≦ 0,5, 0,
0 ≦w ≦ 0,2, dans lequel le facteur de qualité mécanique Qm est inférieur ou égal à 50, la constante de fréquence radiale Np est supérieure ou égale à 2800Hz·m, et la constante piézoélectrique d₃₃ est supérieure ou égale à 250pC/N, et dans lequel la couche d'adaptation acoustique (14) présente une dimension de diamètre externe supérieure ou égale à la dimension de diamètre externe de l'élément piézoélectrique (13) ; et
**caractérisé en outre en ce que**, lorsque la fréquence de résonance radiale de l'élément piézoélectrique (13) est représentée par f, lorsque la vitesse acoustique d'une onde longitudinale se propageant dans la couche d'adaptation acoustique (14) est représentée par c, lorsque la longueur d'onde de l'onde ultrasonore se propageant dans la couche d'adaptation acoustique (14) est représentée par λ, lorsque l'épaisseur de la couche d'adaptation acoustique (14) est représentée par t, alors la relation λ = c/f est satisfaite, ainsi que t = λ/4 ± 20 % , et t/λ est compris entre 0,210 et 0,242 ou entre 0,270 et 0,299, et **caractérisé en ce que**,
lorsqu'une plage de fréquence à la sensibilité d'émission / de réception qui est réduite de 6 dB par rapport à la sensibilité maximale d'émission / de réception est la bande de fréquences, lorsqu'une fréquence limite inférieure dans la bande de fréquences est la fréquence limite inférieure, lorsqu'une fréquence limite supérieure dans la bande de fréquences est la fréquence limite supérieure, lorsqu'une valeur intermédiaire entre la fréquence limite inférieure et la fréquence limite supérieure est la fréquence centrale fm, lorsque la différence entre la fréquence limite inférieure et la fréquence limite supérieure est la largeur de bande de fréquence Δf, et lorsque le rapport entre la largeur de bande Δf et la fréquence centrale fm est la largeur de bande fractionnaire Δf/fm, alors la largeur de bande fractionnaire Δf/fm est supérieure ou égale à 15 %.

3. Capteur ultrasonore (11, 12) selon la revendication 1 ou 2, **caractérisé en ce que** l'épaisseur de la couche d'adaptation acoustique (14) est de λ/4 - 20 % à λ/4 - 1 % ou de λ/4 + 1 % à λ/4 + 20 %.

4. Capteur ultrasonore (11, 12) selon l'une quelconque des revendications 1 à 3, **caractérisé en ce que** l'élément piézoélectrique (13) présente une masse volumique de 4,4 g/cm³ ± 10 %.
